# EUROPEAN PATENT APPLICATION

(11) **EP 4 343 843 A1**
(43) Date of publication of application: **27.03.2024**
(21) Application number: 23195359.7
(22) Date of filing: 05.09.2023
(51) Int. Cl.: H01L 25/10, H01L 23/498, H01L 23/538, H01L 25/065

(54) **MULTI-DIE PACKAGE ON PACKAGE**

(30) Priority: 20.09.2022 US 202263376308 P; 14.08.2023 US 202318233863
(71) Applicant: MediaTek Inc., Hsin-Chu 300 (TW)
(72) Inventor: PENG, Tai-Hao, 30078 Hsinchu City (TW); HUANG, Yao-Tsung, 30078 Hsinchu City (TW)
(74) Representative: Hoefer & Partner Patentanwälte mbB

(57) **Abstract**

A multi-die package on package includes a bottom package having a first device die and a second device die. A top package including a memory die is stacked on the bottom package.

## Description

### Cross Reference to Related Applications

This application claims the benefit of U.S. Provisional Application No. 63/376,308, filed on September 20th, 2022. The content of the application is incorporated herein by reference.

### Background

The present disclosure relates generally to the field of semiconductor packaging. More particularly, the present disclosure relates to a multi-die package on package.

Package-on-Package (PoP) is an integrated circuit packaging method to combine vertically discrete logic and memory ball grid array (BGA) packages. Two or more packages are installed atop each other, i.e. stacked, with a standard interface to route signals between them. This allows higher component density in devices, such as mobile phones or digital cameras.

PoP solutions are commonly used in baseband and applications processors in mobile phones. High-end phones have seen the fastest adoption of PoP packaging to provide high I/O and performance requirements. The main advantage of stacked PoP is that devices can be separately fully tested before assembly.

### Summary

It is one object of the invention to provide an improved package on package to solve the prior art deficiencies or shortcomings. A multi-die package on package according to the invention is defined in the independent claims. The dependent claims define preferred embodiments thereof.

One aspect of the invention provides a multi-die package on package including a bottom package comprising a first device die and a second device die; and a top package comprising a memory die, stacked on the bottom package.

Preferably, the bottom package comprises a first substrate having a top surface and a bottom surface opposite to the top surface.

Preferably, the first substrate comprises a re-distribution layer (RDL) substrate or an organic substrate.

Preferably, the first substrate comprises a first dielectric layer and a first interconnect structure surrounded by the first dielectric layer, wherein the first interconnect structure comprises a plurality of ball pads on the bottom surface for connection with solder balls.

Preferably, the first device die and the second device die are disposed on the top surface of the first substrate in a side-by-side manner, and wherein the first device die is electrically connected to the second device die through the first interconnect structure of the first substrate.

Preferably, the first device die is electrically connected to the second device die through the first interconnect structure of the first substrate and a bridge die disposed on the bottom surface of the first substrate.

Preferably, the first device die and the second device die are disposed on the top surface and the bottom surface of the first substrate, respectively.

Preferably, the first device die is completely overlapped with the second device die when viewed from the above.

Preferably, the multi-die package on package further includes at least one passive element disposed on the bottom surface of the first substrate.

Preferably, the at least one passive element comprises an integrated passive device (IPD) or a multi-layer ceramic capacitor (MLCC).

Preferably, the multi-die package on package further includes an encapsulant on the top surface of the first substrate.

Preferably, the encapsulant surrounds the first device die.

Preferably, the multi-die package on package further includes a plurality of through vias disposed around the first device die on the top surface of the first substrate.

Preferably, the multi-die package on package further includes a second substrate disposed on the through vias and on the encapsulant.

Preferably, the second substrate comprises a re-distribution layer (RDL) substrate or an interposer substrate.

Preferably, the second substrate comprises a second dielectric layer and a second interconnect structure, wherein the second structure is electrically connected to the first interconnect structure of the first substrate through the through vias.

Preferably, the first device die is an application processor die and the second device die is an image signal processor die or a modem die.

Preferably, the first device die is a digital integrated circuit die and the second device die is an analog integrated circuit die.

Preferably, the first device die is a core circuit die and the second device die is an input/output (I/O) circuit die.

Preferably, the first device die and the second device die have different sizes.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a perspective top view of an exemplary multi-die package on package according to one embodiment of the invention;
FIG. 2 is a schematic cross-sectional diagram taken along line I-I' in FIG. 1;
FIG. 3 is a perspective top view of an exemplary multi-die package on package according to another embodiment of the invention;
FIG. 4 is a schematic cross-sectional diagram taken along line I-I' in FIG. 3;
FIG. 5 is a perspective top view of an exemplary multi-die package on package according to still another embodiment of the invention; and
FIG. 6 is a schematic cross-sectional diagram taken along line I-I' in FIG. 5.

### Detailed Description

In the following detailed description of embodiments of the invention, reference is made to the accompanying drawings, which form a part hereof, and in which is shown by way of illustration specific preferred embodiments in which the disclosure may be practiced. These embodiments are described in sufficient detail to enable those skilled in the art to practice them, and it is to be understood that other embodiments may be utilized and that mechanical, structural, and procedural changes may be made without departing from the spirit and scope of the present disclosure. The following detailed description is, therefore, not to be taken in a limiting sense, and the scope of embodiments of the present invention is defined only by the appended claims.

It will be understood that, although the terms first, second, third, primary, secondary, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first or primary element, component, region, layer or section discussed below could be termed a second or secondary element, component, region, layer or section without departing from the teachings of the present inventive concept.

Spatially relative terms, such as "beneath", "below", "lower", "under", "above," "upper," "over" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" or "over" the other elements or features. Thus, the exemplary terms "below" and "under" can encompass both an orientation of above and below. The device may be otherwise oriented (rotated 90 degrees or at other orientations) and the spatially relative descriptors used herein interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to be limiting of the inventive concept. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items, and may be abbreviated as "f'.

It will be understood that when an element or layer is referred to as being "on", "connected to", "coupled to", or "adjacent to" another element or layer, it can be directly on, connected, coupled, or adjacent to the other element or layer, or intervening elements or layers may be present. In contrast, when an element is referred to as being "directly on," "directly connected to", "directly coupled to", or "immediately adjacent to" another element or layer, there are no intervening elements or layers present.

It is noted that: (i) same features throughout the drawing figures will be denoted by the same reference label and are not necessarily described in detail in every drawing that they appear in, and (ii) a sequence of drawings may show different aspects of a single item, each aspect associated with various reference labels that may appear throughout the sequence, or may appear only in selected drawings of the sequence.

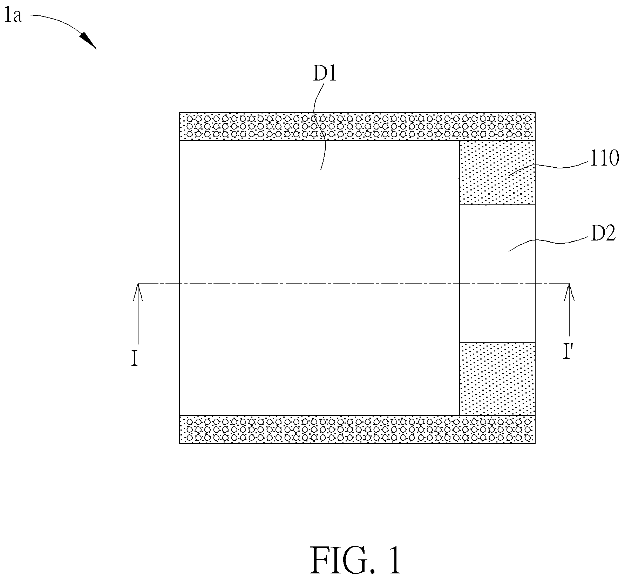

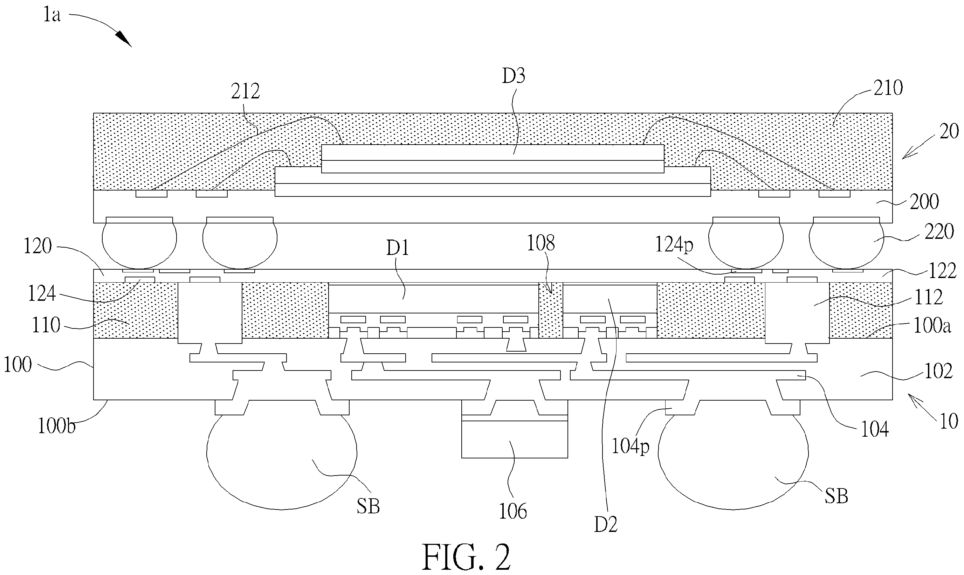

Please refer to FIG. 1 and FIG. 2. FIG. 1 is a perspective top view of an exemplary multi-die package on package according to one embodiment of the invention. FIG. 2 is a schematic cross-sectional diagram taken along line I-I' in FIG. 1. As shown in FIG. 1 and FIG. 2, the multi-die package on package 1a comprises a bottom package 10 and a top package 20 stacked on the bottom package 10. According to an embodiment, the bottom package 10 comprises a substrate 100, for example, a re-distribution layer (RDL) substrate or an organic substrate. The substrate 100 comprises a top surface 100a and a bottom surface 100b opposite to the top surface 100a. According to an embodiment, for example, the substrate 100 may comprise at least one dielectric layer 102 and an interconnect structure 104 surrounded by the at least one dielectric layer 102. The interconnect structure 104 may comprise a plurality of ball pads 104p, which may be provided on the bottom surface 100b for connection with solder balls SB. According to an embodiment, at least one passive element 106 such as an integrated passive device (IPD) or a multi-layer ceramic capacitor (MLCC) may be disposed on the bottom surface 100b for system performance boost.

According to an embodiment, at least two device dies, for example, a device die D1 and a device die D2 are disposed on the top surface 100a of the substrate 100 in a side-by-side manner. According to an embodiment, for example, the discrete device die D1 and device die D2 may comprise system-on-chip (SoC). According to an embodiment, for example, the device die D1 may be an application processor (AP) SoC die and the device die D2 may be an image signal processor (ISP) die or a modem SoC die. According to another embodiment, for example, the device die D1 may be a digital integrated circuit die and the device die D2 may be an analog integrated circuit die. According to still another embodiment, for example, the device die D1 may be a core circuit die and the device die D2 may be an input/output (I/O) circuit die. According to an embodiment, the device die D1 and the device die D2 have different sizes. According to an embodiment, for example, the device die D1 has a surface area that is greater than that of the device die D2. The device die D1 may be electrically connected to the device die D2 through the interconnect structure 104 of the substrate 100.

According to an embodiment, for example, the device die D1 and the device die D2 may be mounted on the top surface 100a of the substrate 100 by using a flip-chip technique. According to another embodiment, for example, the device die D1 and the device die D2 may be electrically connected to the interconnect structure 104 of the substrate 100 through a re-distribution layer. According to an embodiment, for example, the device die D1 and the device die D2 may be surrounded by an encapsulant 110 such as an epoxy molding compound. A gap 108 between the device die D1 and the device die D2 may be filled with the encapsulant 110.

According to an embodiment, for example, a plurality of through vias 112 may be disposed around the device die D1 and the device die D2 on the top surface 100a of the substrate 100. The through vias 112 are surrounded by the encapsulant 110 and a bottom end of each of the through vias 112 may be electrically connected to the interconnect structure 104 of the substrate 100. According to an embodiment, for example, the plurality of through vias 112 may comprise conductive pillars or copper cored solder balls, but not limited thereto. According to an embodiment, for example, a top end of each of the through vias 112 is coplanar with a top surface of the encapsulant 110.

According to an embodiment, an intermediate substrate 120 may be disposed on the through vias 112 and on the top surface of the encapsulant 110. According to an embodiment, for example, the intermediate substrate 120 may be a RDL substrate or an interposer substrate. According to an embodiment, for example, the intermediate substrate 120 may comprise at least one dielectric layer 122 and an interconnect structure 124. The interconnect structure 124 may be electrically connected to the interconnect structure 104 of the substrate 100 through the through vias 112. According to an embodiment, the interconnect structure 124 may comprise a plurality of re-distributed pads 124p for connection with a plurality of connecting elements 220 of a top package 20. According to an embodiment, for example, the connecting elements 220 may comprise conductive bumps or pillars, but not limited thereto.

According to an embodiment, for example, the top package 20 may be a low-power double data rate (LPDDR) dynamic random access memory (DRAM) package comprising at least one DRAM die D3 mounted on a top substrate 200. The DRAM die D3 may be surrounded by an encapsulant 210. According to an embodiment, for example, the DRAM die D3 may be electrically connected to the top substrate 200 through a plurality of bonding wires 212, but not limited thereto.

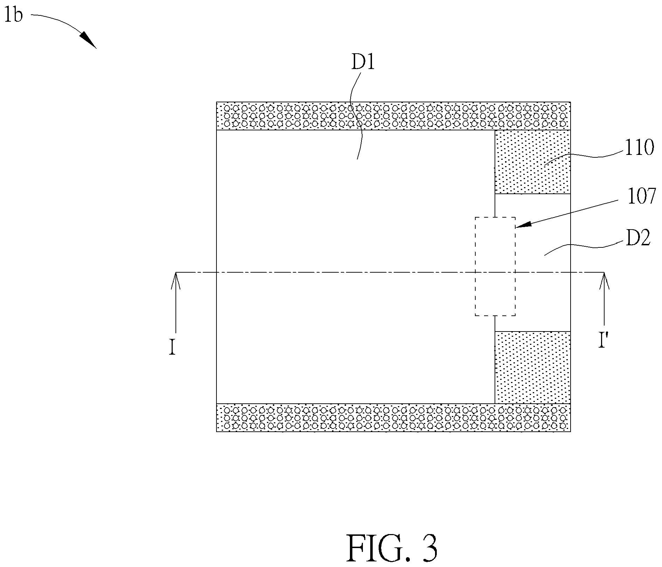

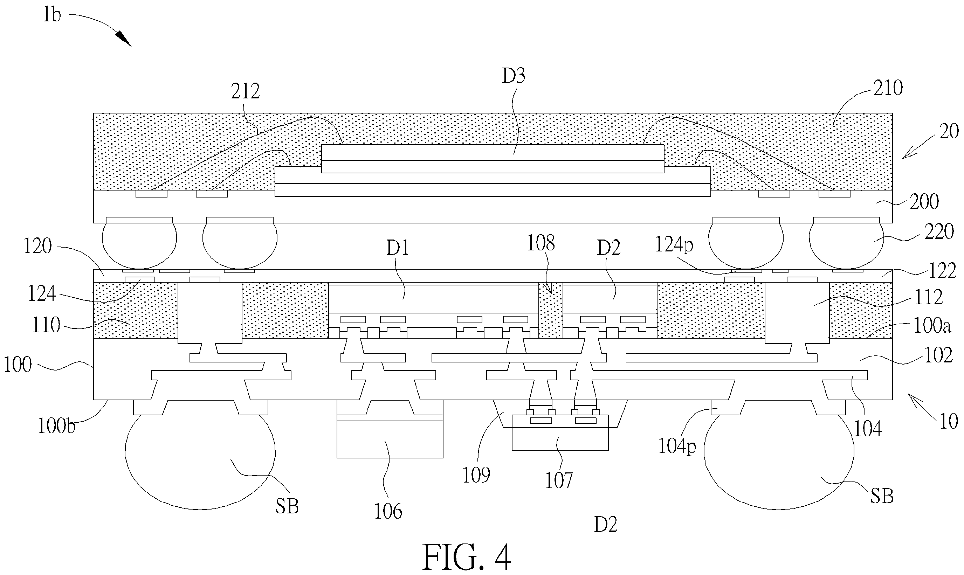

Please refer to FIG. 3 and FIG. 4. FIG. 3 is a perspective top view of an exemplary multi-die package on package according to another embodiment of the invention. FIG. 4 is a schematic cross-sectional diagram taken along line I-I' in FIG. 3, wherein like regions, layers or elements are designated by like numeral numbers or labels. As shown in FIG. 3 and FIG. 4, likewise, the multi-die package on package 1b comprises a bottom package 10 and a top package 20 stacked on the bottom package 10. According to an embodiment, the bottom package 10 comprises a substrate 100, for example, an RDL substrate or an organic substrate. The substrate 100 comprises a top surface 100a and a bottom surface 100b opposite to the top surface 100a. According to an embodiment, for example, the substrate 100 may comprise at least one dielectric layer 102 and an interconnect structure 104 surrounded by the at least one dielectric layer 102. The interconnect structure 104 may comprise a plurality of ball pads 104p, which may be provided on the bottom surface 100b for connection with solder balls SB. According to an embodiment, at least one passive element 106 such as an integrated passive device or a multi-layer ceramic capacitor may be disposed on the bottom surface 100b for system performance boost.

According to an embodiment, a device die D1 and a device die D2 are disposed on the top surface 100a of the substrate 100 in a side-by-side manner. According to an embodiment, for example, the discrete device die D1 and device die D2 may comprise a system-on-chip. According to an embodiment, for example, the device die D1 may be an application processor SoC die and the device die D2 may be an image signal processor die or a modem SoC die. According to another embodiment, for example, the device die D1 may be a digital integrated circuit die and the device die D2 may be an analog integrated circuit die. According to still another embodiment, for example, the device die D1 may be a core circuit die and the device die D2 may be an input/output circuit die. According to an embodiment, the device die D1 and the device die D2 have different sizes. According to an embodiment, for example, the device die D1 has a surface area that is greater than that of the device die D2. The device die D1 may be electrically connected to the device die D2 through the interconnect structure 104 of the substrate 100 and a bridge die 107 disposed on the bottom surface 100b of the substrate 100. For example, the bridge die 107 may be installed on the bottom surface 100b of the substrate 100 by using a flip-chip technique. The gap between the bridge die 107 and the bottom surface 100b of the substrate 100 may be filled with an underfill 109.

According to an embodiment, for example, the device die D1 and the device die D2 may be mounted on the top surface 100a of the substrate 100 by using a flip-chip technique. According to another embodiment, for example, the device die D1 and the device die D2 may be electrically connected to the interconnect structure 104 of the substrate 100 through a re-distribution layer. According to an embodiment, for example, the device die D1 and the device die D2 may be surrounded by an encapsulant 110 such as an epoxy molding compound. A gap 108 between the device die D1 and the device die D2 may be filled with the encapsulant 110.

According to an embodiment, likewise, a plurality of through vias 112 may be disposed around the device die D1 and the device die D2 on the top surface 100a of the substrate 100. The through vias 112 are surrounded by the encapsulant 110 and a bottom end of each of the through vias 112 may be electrically connected to the interconnect structure 104 of the substrate 100. According to an embodiment, for example, the plurality of through vias 112 may comprise conductive pillars or copper cored solder balls, but not limited thereto. According to an embodiment, for example, a top end of each of the through vias 112 is coplanar with a top surface of the encapsulant 110.

According to an embodiment, an intermediate substrate 120 may be disposed on the through vias 112 and on the top surface of the encapsulant 110. According to an embodiment, for example, the intermediate substrate 120 may be a RDL substrate or an interposer substrate. According to an embodiment, for example, the intermediate substrate 120 may comprise at least one dielectric layer 122 and an interconnect structure 124. The interconnect structure 124 may be electrically connected to the interconnect structure 104 of the substrate 100 through the through vias 112. According to an embodiment, the interconnect structure 124 may comprise a plurality of re-distributed pads 124p for connection with a plurality of connecting elements 220 of a top package 20. According to an embodiment, for example, the connecting elements 220 may comprise conductive bumps or pillars, but not limited thereto.

According to an embodiment, for example, the top package 20 may be an LPDDR DRAM package comprising at least one DRAM die D3 mounted on a top substrate 200. The DRAM die D3 may be surrounded by an encapsulant 210. According to an embodiment, for example, the DRAM die D3 may be electrically connected to the top substrate 200 through a plurality of bonding wires 212, but not limited thereto.

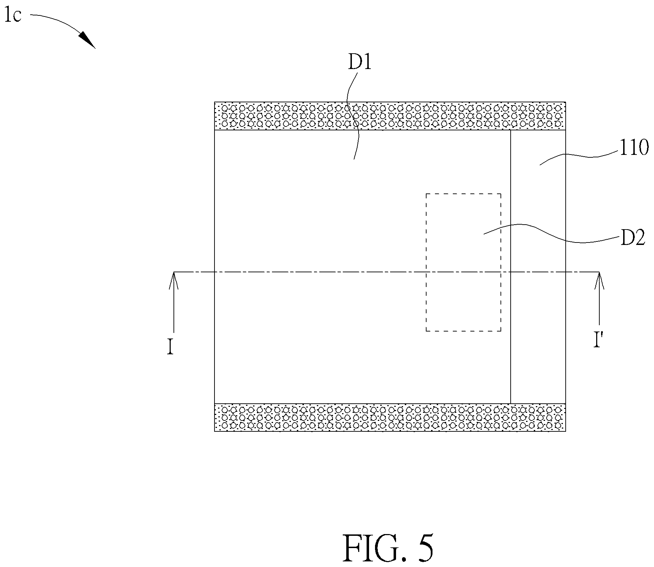

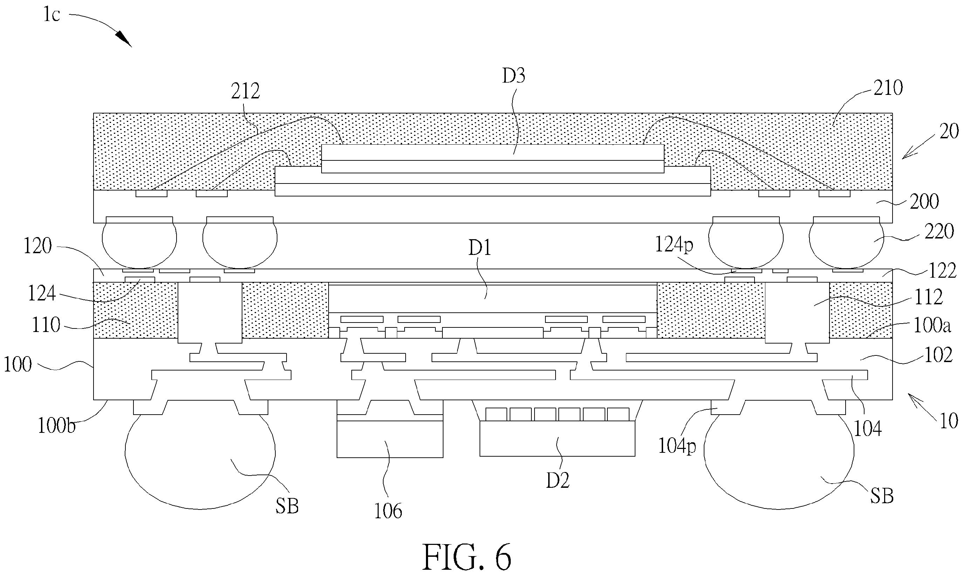

Please refer to FIG. 5 and FIG. 6. FIG. 5 is a perspective top view of an exemplary multi-die package on package according to still another embodiment of the invention. FIG. 6 is a schematic cross-sectional diagram taken along line I-I' in FIG. 5, wherein like regions, layers or elements are designated by like numeral numbers or labels. As shown in FIG. 5 and FIG. 6, likewise, the multi-die package on package 1c comprises a bottom package 10 and a top package 20 stacked on the bottom package 10. According to an embodiment, the bottom package 10 comprises a substrate 100, for example, an RDL substrate or an organic substrate. The substrate 100 comprises a top surface 100a and a bottom surface 100b opposite to the top surface 100a. According to an embodiment, for example, the substrate 100 may comprise at least one dielectric layer 102 and an interconnect structure 104 surrounded by the at least one dielectric layer 102. The interconnect structure 104 may comprise a plurality of ball pads 104p, which may be provided on the bottom surface 100b for connection with solder balls SB. According to an embodiment, at least one passive element 106 such as an integrated passive device or a multi-layer ceramic capacitor may be disposed on the bottom surface 100b for system performance boost.

According to an embodiment, a device die D1 and a device die D2 are disposed on the top surface 100a and the bottom surface 100b of the substrate 100, respectively. As can be seen in FIG. 5, the device die D1 is completely overlapped with the device die D2 when viewed from the above. According to an embodiment, for example, the discrete device die D1 and device die D2 may comprise a system-on-chip. According to an embodiment, for example, the device die D1 may be an application processor SoC die and the device die D2 may be an image signal processor die or a modem SoC die. According to another embodiment, for example, the device die D1 may be a digital integrated circuit die and the device die D2 may be an analog integrated circuit die. According to still another embodiment, for example, the device die D1 may be a core circuit die and the device die D2 may be an input/output circuit die. According to an embodiment, the device die D1 and the device die D2 have different sizes. According to an embodiment, for example, the device die D1 has a surface area that is greater than that of the device die D2. The device die D1 may be electrically connected to the device die D2 through the interconnect structure 104 of the substrate 100.

According to an embodiment, for example, the device die D1 and the device die D2 may be mounted on the substrate 100 by using a flip-chip technique. According to another embodiment, for example, the device die D1 and the device die D2 may be electrically connected to the interconnect structure 104 of the substrate 100 through a re-distribution layer. According to an embodiment, for example, the device die D1 may be surrounded by an encapsulant 110 such as an epoxy molding compound.

According to an embodiment, for example, a plurality of through vias 112 may be disposed around the device die D1 on the top surface 100a of the substrate 100. The through vias 112 are surrounded by the encapsulant 110 and a bottom end of each of the through vias 112 may be electrically connected to the interconnect structure 104 of the substrate 100. According to an embodiment, for example, the plurality of through vias 112 may comprise conductive pillars or copper cored solder balls, but not limited thereto. According to an embodiment, for example, a top end of each of the through vias 112 is coplanar with a top surface of the encapsulant 110.

According to an embodiment, an intermediate substrate 120 may be disposed on the through vias 112 and on the top surface of the encapsulant 110. According to an embodiment, for example, the intermediate substrate 120 may be a RDL substrate or an interposer substrate. According to an embodiment, for example, the intermediate substrate 120 may comprise at least one dielectric layer 122 and an interconnect structure 124. The interconnect structure 124 may be electrically connected to the interconnect structure 104 of the substrate 100 through the through vias 112. According to an embodiment, the interconnect structure 124 may comprise a plurality of re-distributed pads 124p for connection with a plurality of connecting elements 220 of a top package 20. According to an embodiment, for example, the connecting elements 220 may comprise conductive bumps or pillars, but not limited thereto.

According to an embodiment, for example, the top package 20 may be an LPDDR DRAM package comprising at least one DRAM die D3 mounted on a top substrate 200. The DRAM die D3 may be surrounded by an encapsulant 210. According to an embodiment, for example, the DRAM die D3 may be electrically connected to the top substrate 200 through a plurality of bonding wires 212, but not limited thereto.

Those skilled in the art will readily observe that numerous modifications and alterations of the device may be made while retaining the teachings of the invention. Accordingly, the above disclosure should be construed as limited only by the metes and bounds of the appended claims.

## Claims

1. A multi-die package on package, comprising:
a bottom package comprising a first device die and a second device die; and
a top package comprising a memory die, stacked on the bottom package.

2. The multi-die package on package according to claim 1, wherein the bottom package comprises a first substrate having a top surface and a bottom surface opposite to the top surface.

3. The multi-die package on package according to claim 2, wherein the first substrate comprises a re-distribution layer (RDL) substrate or an organic substrate.

4. The multi-die package on package according to claim 2, wherein the first substrate comprises a first dielectric layer and a first interconnect structure surrounded by the first dielectric layer, wherein the first interconnect structure comprises a plurality of ball pads on the bottom surface for connection with solder balls.

5. The multi-die package on package according to claim 4, wherein the first device die and the second device die are disposed on the top surface of the first substrate in a side-by-side manner, and wherein the first device die is electrically connected to the second device die through the first interconnect structure of the first substrate; preferably wherein the first device die is electrically connected to the second device die through the first interconnect structure of the first substrate and a bridge die disposed on the bottom surface of the first substrate.

6. The multi-die package on package according to claim 2, wherein the first device die and the second device die are disposed on the top surface and the bottom surface of the first substrate, respectively; preferably wherein the first device die is completely overlapped with the second device die when viewed from the above.

7. The multi-die package on package according to claim 2 further comprising:
at least one passive element disposed on the bottom surface of the first substrate; preferably wherein the at least one passive element comprises an integrated passive device (IPD) or a multi-layer ceramic capacitor (MLCC).

8. The multi-die package on package according to claim 4 further comprising:
an encapsulant on the top surface of the first substrate.

9. The multi-die package on package according to claim 8, wherein the encapsulant surrounds the first device die.

10. The multi-die package on package according to claim 8 further comprising:
a plurality of through vias disposed around the first device die on the top surface of the first substrate.

11. The multi-die package on package according to claim 10 further comprising:
a second substrate disposed on the through vias and on the encapsulant.

12. The multi-die package on package according to claim 11, wherein the second substrate comprises a re-distribution layer (RDL) substrate or an interposer substrate.

13. The multi-die package on package according to claim 11, wherein the second substrate comprises a second dielectric layer and a second interconnect structure, wherein the second structure is electrically connected to the first interconnect structure of the first substrate through the through vias.

14. The multi-die package on package according to any preceding claim,
• wherein the first device die is an application processor die and the second device die is an image signal processor die or a modem die,
• or wherein the first device die is a digital integrated circuit die and the second device die is an analog integrated circuit die,
• or wherein the first device die is a core circuit die and the second device die is an input/output (I/O) circuit die.

15. The multi-die package on package according to any preceding claim, wherein the first device die and the second device die have different sizes.
